# EUROPEAN PATENT SPECIFICATION

(11) **EP 3 128 047 B1**
(45) Date of publication and mention of the grant of the patent: **26.09.2018**
(21) Application number: 15773120.9
(22) Date of filing: 10.03.2015
(51) Int. Cl.: H01L 21/3065, H01L 21/302, H01L 21/324, H01L 21/205, H01L 21/67, C30B 19/04, C30B 19/12, C30B 29/36, C30B 33/12, H01L 21/02, H01L 29/16

(54) **METHOD FOR REMOVING WORK-AFFECTED LAYER OF SIC SEED CRYSTAL, AND SIC SUBSTRATE MANUFACTURING METHOD**
VERFAHREN ZUR ENTFERNUNG EINER ARBEITSBEEINTRÄCHTIGTEN SCHICHT VON EINEM SIC-IMPFKRISTALL, UND SIC-SUBSTRAT-HERSTELLUNGSVERFAHREN
PROCÉDÉ POUR L'ÉLIMINATION D'UNE COUCHE ALTÉRÉE PAR LE TRAVAIL D'UN GERME CRISTALLIN DE SIC, ET PROCÉDÉ DE FABRICATION D'UN SUBSTRAT EN SIC

(30) Priority: 31.03.2014 JP 2014074742
(43) Date of publication of application: 08.02.2017
(73) Proprietor: Toyo Tanso Co., Ltd., Osaka-shi, Osaka 555-0011 (JP)
(72) Inventor: YABUKI, Norihito, Kanonji-shi Kagawa 769-1612 (JP); TORIMI, Satoshi, Kanonji-shi Kagawa 769-1612 (JP); NOGAMI, Satoru, Kanonji-shi Kagawa 769-1612 (JP)
(74) Representative: TBK
(86) International application number: PCT/JP2015/001302
(87) International publication number: WO 2015/151412

(56) References cited:
- JP-A- 2003 234 313
- JP-A- 2008 016 691
- JP-A- 2008 016 691
- JP-A- 2009 218 575
- JP-A- 2010 265 126

## Description

### TECHNICAL FIELD

The present invention relates to a method for removing a work-affected layer of a SiC seed crystal manufactured by cutting, and a method of manufacturing a SiC substrate using the SiC seed crystal in which the work-affected layer is removed.

### BACKGROUND ART

SiC, which is superior to Si, etc., in terms of heat resistance, electrical characteristics, and the like, has been attracting attention as a new semiconductor material. To manufacture a semiconductor element, firstly, a SiC substrate (SiC bulk substrate) is manufactured by using a seed crystal made of a SiC single crystal. Next, an epitaxial wafer is manufactured by causing a growth of an epitaxial layer on the SiC substrate. The semiconductor element is manufactured by the epitaxial wafer. A MSE process has been known as a method for causing the growth of the SiC single crystal using the seed crystal.

Patent Document 1 discloses a method for causing the growth of a SiC single crystal using MSE process. MSE process uses a SiC seed crystal made of the SiC single crystal, a feed substrate having a higher free energy than that of the SiC seed substrate, and Si melt. The SiC seed crystal and the feed substrate are arranged opposed to each other and the Si melt is interposed therebetween. Then, a heat treatment is performed in a vacuum, thus causing the growth of the SiC single crystal on a surface of the SiC seed crystal.

Non-Patent Document 1 discloses that the growth of the SiC single crystal by MSE process is hindered by crystal defects. In Non-patent Document 1, the threading screw dislocation (TSD) has the largest rate of hindrance to the growth, the basal plane dislocation (BPD) has a small rate of hindrance to the growth, and the threading edge dislocation (TED) hardly hinders the growth.

Patent Documents 2 to 5 disclose treatment methods for removing a surface modified layer formed on the SiC substrate. Patent Document 2 describes that the surface modified layer is a damage layer of a crystal structure occurring in a step of manufacturing the SiC substrate (mechanical processing such as mechanical polishing), and describes hydrogen etching as a method for removing the surface modified layer. Patent Documents 3 to 5 suggest planarizing the SiC substrate by thermal etching.

### PRIOR-ART DOCUMENTS

### PATENT DOCUMENTS

PATENT DOCUMENT 1: JP 2008 230946 A
PATENT DOCUMENT 2: WO 2011/024931 A1
PATENT DOCUMENT 3: JP 2008 016691 A
PATENT DOCUMENT 4: JP 2003 234313 A
PATENT DOCUMENT 5: JP 2010 265126 A

### NON-PATENT DOCUMENTS

NON-PATENT DOCUMENT 1: Shinkichi Hamada and five others, "Dislocation conversion mechanisms by MSE growth", Spring Proceedings of Applied Physics, The Japan Society of Applied Physics, March 11, 2013, 60th volume

### SUMMARY OF THE INVENTION

### PROBLEMS TO BE SOLVED BY THE INVENTION

The applicant has found that the rate of growth is extremely lowered if MSE process is performed using a SiC single crystal, as a SiC seed crystal, which is cut by a diamond saw or the like. MSE process is expected because a high-quality SiC substrate can be manufactured by MSE process rather than the sublimation-recrystallization process. Therefore, the problem needs to be overcome.

Patent Document 2 discloses that a work-affected layer exists in the SiC substrate which is grown from the SiC seed crystal, and the work-affected layer is removed. The work-affected layer of the SiC seed crystal is not described in Patent Document 2.

The present invention has been made in view of the circumstances described above, and a primary object of the present invention is to provide a method for preventing the rate of growth from lowering when MSE process is performed using a cut SiC seed crystal.

### MEANS FOR SOLVING THE PROBLEMS AND EFFECTS THEREOF

Problems to be solved by the present invention are as described above, and next, means for solving the problems and effects thereof will be described.

In a first aspect of the present invention, there is provided a method for removing a work-affected layer that is caused by cutting in a SiC single crystal, the method including the features set out in claim 1.

Accordingly, the work-affected layer as hindrance to the growth of MSE process can be removed, which can prevent lowering of the rate of growth of MSE process.

In the method for removing the work-affected layer of the SiC seed crystal, the SiC seed crystal has a plate-like shape and the surface parallel to the thickness direction in the SiC seed crystal is etched.

Accordingly, a portion where the work-affected layer occurred is surely removed.

In the method for removing the work-affected layer of the SiC seed crystal, the amount of etching in the etching step is 10µm or more.

This improves the rate of growth in MSE process.

In a second aspect of the present invention, there is provided a method for manufacturing a SiC substrate including the features set out in claim 2.

Accordingly, the rate of growth in MSE process is not lowered, which can efficiently manufacture the SiC substrate.

### BRIEF DESCRIPTION OF THE DRAWINGS

[Fig. 1] A diagram for illustration of an outline of a high-temperature vacuum furnace for use in etching of a SiC seed crystal according to the present invention.
[Fig. 2] A schematic view showing a configuration example when a SiC single crystal is grown by MSE process.
[Fig. 3] A perspective view and a cross-sectional view showing a situation when the SiC seed crystal is etched.
[Fig. 4] A graph showing the time of etching and the amount of etching in the SiC seed crystal.
[Fig. 5] Diagrams explaining a change of a surface form of the SiC seed crystal depending on the time of etching.
[Fig. 6] A graph showing a relationship between the amount of etching in the SiC seed crystal and the rate of growth in MSE process.

### EMBODIMENT FOR CARRYING OUT THE INVENTION

Next, an embodiment of the present invention will be described with reference to the drawings.

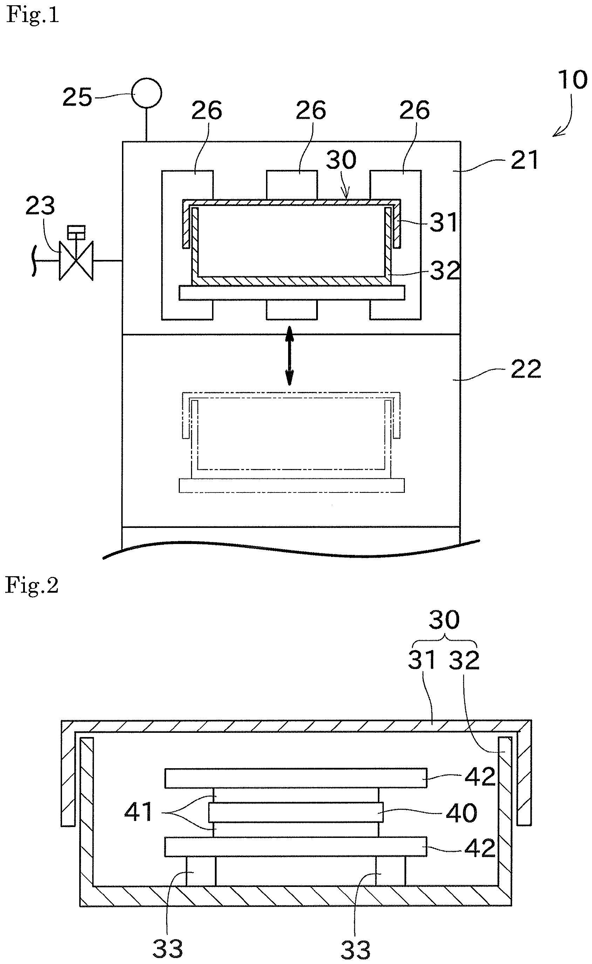

Firstly, referring to Fig. 1, a high-temperature vacuum furnace 10 for use in a heat treatment (etching) of this embodiment will be described. Fig. 1 is a diagram for illustration of an outline of a high-temperature vacuum furnace for use in a surface treatment method of the present invention.

As shown in Fig. 1, the high-temperature vacuum furnace 10 includes a main heating chamber 21 and a preheating chamber 22. The main heating chamber 21 is configured to heat an object to be treated that is made of, at least in its surface, SiC single crystal, up to a temperature of 1000°C or more and 2300°C or less. The preheating chamber 22 is a space for preheating prior to heating the object to be treated in the main heating chamber 21.

A vacuum-forming valve 23, an inert gas injection valve 24, and a vacuum gauge 25 are connected to the main heating chamber 21. The vacuum-forming valve 23 is configured to adjust the degree of vacuum of the main heating chamber 21. The vacuum gauge 25 is configured to measure the degree of vacuum of the interior of the main heating chamber 21.

Heaters 26 are provided in the main heating chamber 21. Heat reflection metal plates (not shown) are secured to side walls and a ceiling of the main heating chamber 21. The heat reflection metal plates are configured to reflect heat of the heaters 26 toward a central region of the main heating chamber 21. This provides strong and uniform heating of a SiC substrate 40, to cause a temperature rise up to 1000°C or more and 2300°C or less. Examples of the heaters 26 include, for example, resistive heaters and high-frequency induction heaters.

The object to be treated is heated while stored in a crucible (storing container) 30. The crucible 30 is placed on an appropriate support or the like, and the support is movable at least in a range from the preheating chamber to the main heating chamber.

The crucible 30 includes an upper container 31 and a lower container 32 that are fittable with each other. The crucible 30 is made of tantalum metal, and includes a tantalum carbide layer that is exposed to an internal space of the crucible 30. Si as a Si supply source with proper form is placed in the crucible 30.

To perform a heat treatment on the object to be treated, as indicated by a chain line in Fig. 1, the crucible 30 is placed in the preheating chamber 22 of the high-temperature vacuum furnace 10, and preheated at a proper temperature (for example, about 800°C). Then, the crucible 30 is moved into the main heating chamber 21 in which the temperature has been preliminarily raised to a set temperature (for example, about 1800°C), whereby the object to be treated is heated. The preheating may be omitted.

Next, a method for manufacturing the SiC substrate by the growth of the SiC single crystal from the SiC seed crystal using MSE process will be described. Fig. 2 is a schematic view showing a configuration example when the SiC single crystal is grown by MSE process.

As shown in Fig. 2, a SiC seed crystal 40, two Si plates 41, and two carbon feed substrates 42 are placed within the crucible 30. They are supported by a support 33.

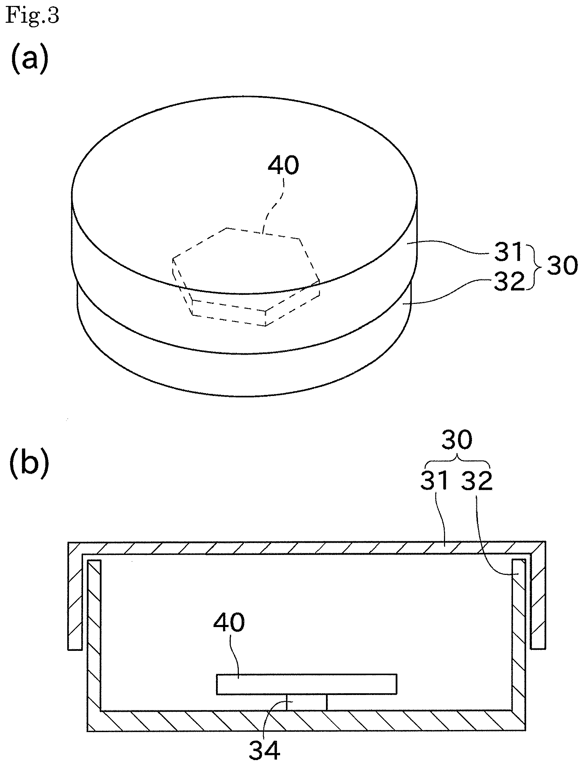

The SiC seed crystal 40 is used as a substrate (seed-side member). The SiC seed crystal 40 is manufactured by dicing (cutting) of a 4H-SiC single crystal having a predetermined size, for example. As shown in Fig. 3, the SiC seed crystal 40 of this embodiment is a hexagonal plate-like member, but any shape is adoptable. 6H-SiC may be used instead of 4H-SiC. Si plates 41 are placed above and below the SiC seed crystal 40.

The Si plates 41 are plate-like members made of Si. The melting point of Si is about 1400°C, and therefore the Si plates 41 are melted by heating in the above-described high-temperature vacuum furnace 10. Carbon feed substrates 42 are placed above and below the Si plates 41.

The carbon feed substrates 42 are used as a material for supplying carbon, that is, as a feed-side. The carbon feed substrates 42 made of polycrystalline 3C-SiC, has a higher free energy than that of the SiC seed crystal 40.

The SiC seed crystal 40, the Si plates 41, and the carbon feed substrates 42 are placed as described above, and then heated at 1800°C, for example. Then, the Si plates 41 placed between the SiC seed crystal 40 and the carbon feed substrates 42 are melted and thereby a silicon melt is worked as a solvent for moving carbon.

Accordingly, the growth of the SiC single crystal by MSE process can be caused on the surface of the SiC seed crystal 40. This can manufacture the SiC substrate that is planar at the atomic level with less micropipe and crystal defects. For the SiC substrate, a step of causing the growth of an epitaxial layer by CVD process (chemical vapor deposition process), LPE process (liquid-phase epitaxial process) or the like, a step of implanting ions, an annealing step of activating ions, etc. are performed to manufacture a semiconductor element.

The applicant has found that the rate of growth of the SiC single crystal may be extremely lowered when MSE process is performed using the SiC seed crystal 40. Moreover, the applicant has also found that this phenomenon occurs when using the SiC seed crystal 40 which is manufactured by cutting such as dicing. Based on the findings, the applicant has considered that a work-affected layer occurs by applying stress to the SiC seed crystal 40 at a time of cutting and the growth of the crystal is hindered by the work-affected layer. Then, the applicant has proposed a method for removing the work-affected layer.

Specifically, the method is for removing the work-affected layer by heating the surface of the SiC seed crystal 40 under Si atmosphere and then etching, prior to performing MSE process. The method will be described with reference to Fig. 3. Fig. 3 contains a perspective view and a cross-sectional view showing a situation when the SiC seed crystal 40 is etched.

The SiC seed crystal 40 is etched by heating the crucible 30 storing the SiC seed crystal 40 therein, in the high-temperature vacuum furnace 10. As shown in Fig. 3, the SiC seed crystal 40 is placed within the above-described crucible 30. In this embodiment, the SiC seed crystal 40 is supported by a support 34, but the support 34 may be omitted. The portion where the work-affected layer of the SiC seed crystal 40 occurred, that is, on and near a side surface (a surface parallel to the thickness direction) of the SiC seed crystal 40 is preferably kept exposed.

As described above, Si supply source is placed within the crucible 30 for causing Si atmosphere within the crucible 30 at a time of heating. Solid Si pellets, Si adhered to inner walls within the crucible 30, or the inner walls made of tantalum silicide may be used as Si supply source. The etching is performed by heating the crucible 30 (the SiC seed crystal 40) under an environment of 1500°C or more and 2200°C or less, desirably 1800°C or more and 2000°C or less. After heating, Si supply source causes Si atmosphere within the crucible 30.

As a result of heating the SiC seed crystal 40 under Si vapor pressure, SiC of the SiC seed crystal 40 is sublimated into Si₂C or SiC₂, and Si under Si atmosphere and C are bonded on the surface of the SiC seed crystal 40. This leads to self-organization. Accordingly, the work-affected layer that occurred on a side surface of the SiC seed crystal and near the side surface is removed. This can prevent lowering of the rate of growth when performing MSE process, even in the SiC seed crystal 40 manufactured by cutting such as dicing.

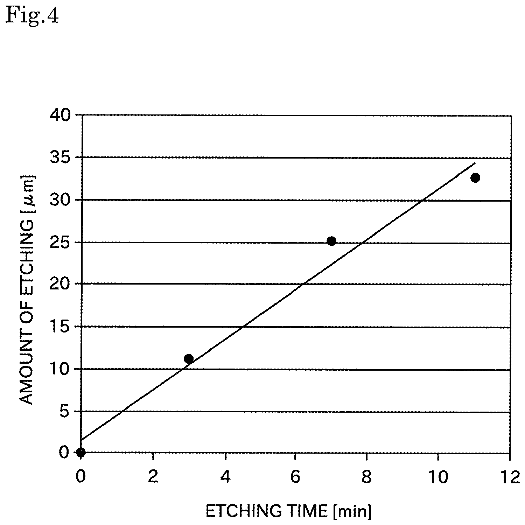

Next, an experiment performed by the applicant in order to confirm the effect of the above-described method will be described with reference to Fig. 4 to Fig. 6.

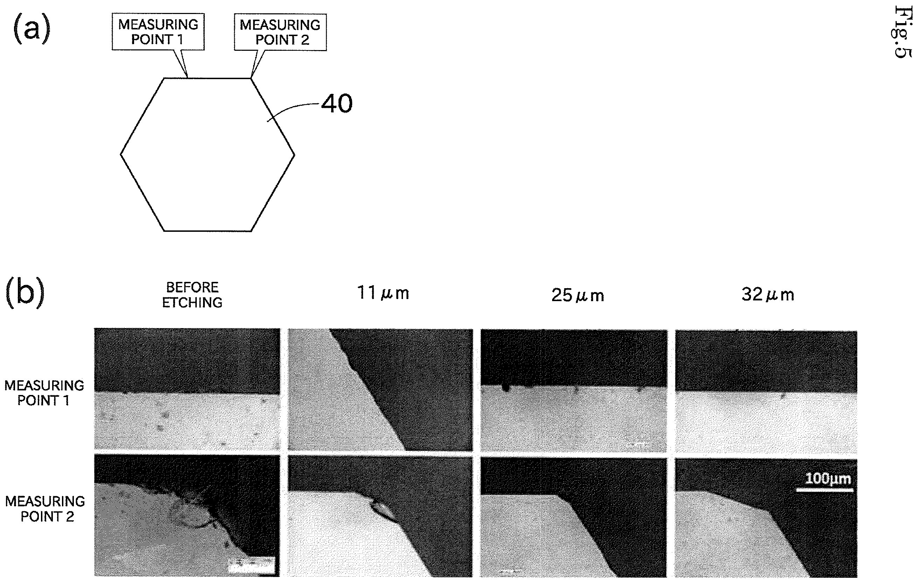

Fig. 4 and Fig. 5 are drawings showing a result when the SiC seed crystal 40 is etched. In this experiment, four SiC seed crystals 40 having the same configuration were prepared, and three of them were heated at 1800°C, 10⁻⁵Pa, for three minutes, seven minutes and eleven minutes respectively.

As shown in Fig. 4, as a result of heat treatment, the amount of etching was 11µm in the SiC seed crystal 40 after heating for three minutes, the amount of etching was 25µm in the SiC seed crystal 40 after heating for seven minutes, and the amount of etching is 32µm in the SiC seed crystal 40 after heating for eleven minutes. The amount of etching was increased as the etching time gets longer. There was a proportional connection between the etching time and the amount of etching. Thus, measuring the etching time enables the desirable amount of etching to be performed to the SiC seed crystal 40.

Fig. 5 contains photomicrographs as seen from the top (from one side of the thickness direction). As shown in Fig. 5 (a), a measuring point 1 represents a side of hexagon, and a measuring point 2 represents a vertex of hexagon. The number written in an upper portion of Fig. 5 (b) shows the amount of etching. As shown in photomicrographs, especially the photomicrograph of the measuring point 2, roughness caused by partially chipping occurred on an end portion of the SiC seed crystal 40. As the SiC seed crystal 40 had larger amount of etching, chip in the end portion was further removed. The significant improvement could be seen in the amount of etching of 10µm. In the amount of etching of 25µm and 32µm, it could be seen that chip in the end portion was substantially completely removed and its end surface was planarized.

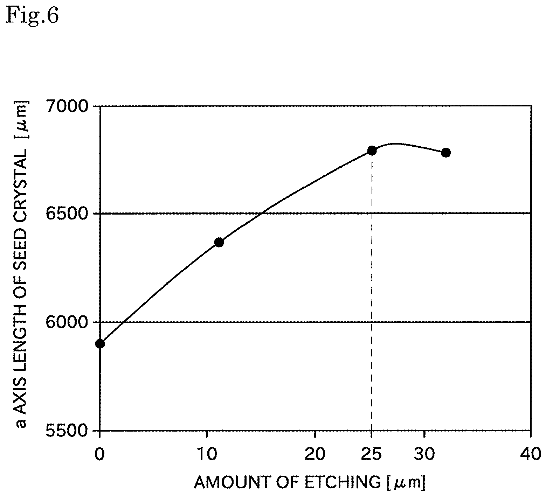

Next, an experiment about a relationship between the amount of etching and the rate of growth will be described with reference to Fig. 6. In this experiment, as described in Fig. 2, the Si plates 41 and carbon feed substrates 42 were placed and then heated for a predetermined time, at 1800°C, with the inert gas pressure of 10 torr. Then, the SiC seed crystal 40 was taken out, and the length in "a" axis direction (epitaxial growth direction) was measured.

It can be seen that, in Fig. 6, as the amount of etching is larger, the length in "a" axis direction of the SiC seed crystal 40 is longer (that is, the rate of growth is higher). Specifically, the rate of growth in the SiC seed crystal 40 having the amount of etching of 10µm was clearly higher than the rate of growth in the SiC seed crystal 40 without etching. Furthermore, the rate of growth in the SiC seed crystal 40 having the amount of etching of 25µm was higher. Both of cases that the etching amount was 25µm and 32µm in the SiC seed crystal 40, the rate of growth was almost the same.

According to the experiment, the amount of etching is preferably 10µm or more, more preferably, the amount of etching is 25µm or more. Thus, etching of the SiC seed crystal 40 can prevent lowering of the rate of growth in MSE process.

The work-affected layer of the seed crystal has not been removed conventionally, but generally, chemical mechanical polishing, hydrogen etching or the like are used as a method for removing the work-affected layer of the SiC substrate (SiC bulk substrate). However, although performing chemical mechanical polishing can easily polish an upper surface or lower surface of the SiC seed crystal 40, it is difficult to polish a side surface of the SiC seed crystal 40. Moreover, the rate of polishing in chemical mechanical polishing is 1 µm/h or less, and the rate of etching in hydrogen etching is several tens of nm/h to several hundreds of nm/h. Therefore, it takes a lot of time in a conventional method for removing the work-affected layer.

In this respect, as it can be seen in the result shown in Fig. 4, in etching by heating under Si vapor pressure (under Si atmosphere), the rate of etching is 3µm/min to 4µm/min. Therefore, the work-affected layer of the SiC seed crystal 40 can be removed in a short time.

As described above, in this embodiment, the SiC seed crystal 40 that is manufactured by dicing and used as a seed crystal in MSE process is heated under Si atmosphere and thereby its surface is etched. Then, the work-affected layer formed on the SiC seed crystal 40 is removed.

Accordingly, since the work-affected layer that hinders the growth of MSE process can be removed, lowering of the rate of growth can be prevented.

In the SiC seed crystal 40 having a plate-like shape, at least its surface parallel to the thickness direction in the SiC seed crystal 40 is etched.

Accordingly, a portion in which the work-affected layer was formed is surely removed. This can further surely prevent lowering of the rate of growth.

Although a preferred embodiment of the present invention has been described above, the above-described configuration can be modified, for example, as follows.

In controlling the amount of etching, not only the etching time but also the temperature, the inert gas pressure, the Si pressure and the like may be used.

The above-described temperature condition, the pressure condition and the like, are merely illustrative, and they are appropriately changeable. Moreover, a heating apparatus other than the above-described high-temperature vacuum furnace 10 is adoptable, and a container having a shape or material different from the crucible 30 is adoptable.

An appropriate method for cutting may be mechanical processing such as dicing, the processing by energy wave such as laser processing, or the like.

### DESCRIPTION OF THE REFERENCE NUMERALS

- 10: high-temperature vacuum furnace
- 30: crucible
- 40: SiC seed crystal
- 41: Si plate
- 42: carbon feed substrate

## Claims

1. A method for removing a work-affected layer of a SiC seed crystal, the work-affected layer caused by cutting in a SiC single crystal, wherein the SiC seed crystal has a plate-like shape and is to be used as a seed crystal for growth of a SiC single crystal in "a" axis direction by metastable solvent epitaxy process, the method comprising:
an etching step of etching a surface parallel to a thickness direction of the SiC seed crystal by heating under Si atmosphere of 1500°C or more and 2200°C or less, thereby removing the work-affected layer that occurred on a side surface of the SiC seed crystal and near the side surface, wherein the amount of etching of the surface parallel to the thickness direction of the SiC seed crystal is 10 µm or more.

2. A method for manufacturing a SiC substrate, the method comprising:
a removal step of removing the work-affected layer of the SiC seed crystal by the method for removing the work-affected layer of the SiC seed crystal according to claim 1; and
a growth step of causing growth of a SiC single crystal in "a" axis direction by metastable solvent epitaxy process, using the SiC seed crystal in which the work-affected layer is removed in the removal step.

## Patentansprüche

1. Verfahren zur Entfernung einer bearbeitungsbeeinträchtigten Schicht eines SiC-Impfkristalls, die durch Schneiden in einem SiC-Einkristall hervorgerufen wurde, wobei der SiC-Impfkristall eine plattenartige Form hat und als ein Impfkristall zur Züchtung eines SiC-Einkristalls in einer "a"-Achsenrichtung durch einen metastabilen Lösungsepitaxieprozess zu verwenden ist und das Verfahren Folgendes umfasst:
einen Ätzschritt, in dem eine Oberfläche, die parallel zu einer Dickenrichtung des SiC-Impfkristalls ist, durch Erhitzen in einer Si-Atmosphäre von 1500°C oder mehr und 2200°C oder weniger geätzt wird,
wodurch die bearbeitungsbeeinträchtigte Schicht entfernt wird, die auf einer Seitenfläche des SiC-Impfkristalls und nahe der Seitenfläche auftrat,
wobei die Ätzmenge der Oberfläche, die parallel zur Dickenrichtung des SiC-Impfkristalls ist, 10 µm oder mehr beträgt.

2. Verfahren zur Herstellung eines SiC-Substrats, wobei das Verfahren Folgendes umfasst:
einen Entfernungsschritt, in dem die bearbeitungsbeeinträchtige Schicht des SiC-Impfkristalls durch das Verfahren zur Entfernung der bearbeitungsbeeinträchtigten Schicht des SiC-Impfkristalls gemäß Anspruch 1 entfernt wird; und
einen Züchtungsschritt, in dem unter Verwendung des SiC-Impfkristalls, bei dem im Entfernungsschritt die bearbeitungsbeeinträchtigte Schicht entfernt ist, durch einen metastabilen Lösungsepitaxieprozess ein SiC-Einkristall in einer "a"-Achsenrichtung wachsen gelassen wird.

## Revendications

1. Procédé d'élimination d'une couche affectée par l'usinage d'un germe cristallin SiC, la couche étant affectée par l'usinage suite à sa découpe dans un monocristal de SiC, dans lequel le germe cristallin SiC a la forme d'une plaque et doit être utilisé comme germe cristallin pour la croissance d'un monocristal SiC dans le sens de l'axe "a" par un procédé d'épitaxie par solvant métastable, le procédé comprenant :
une étape de gravure pour graver une surface parallèle au sens de l'épaisseur du germe cristallin SiC par chauffage dans une atmosphère de Si à 1 500 °C ou plus et 2 200 °C ou moins,
pour éliminer ainsi la couche affectée par l'usinage qui est présente sur une surface latérale du germe cristallin SiC et près de la surface latérale,
dans lequel la quantité de gravure de la surface parallèle au sens de l'épaisseur du germe cristallin SiC est de 10 µm ou moins.

2. Procédé de fabrication d'un substrat en SiC, le procédé comprenant :
une étape d'élimination pour éliminer la couche affectée par l'usinage du germe cristallin SiC par le procédé d'élimination de la couche affectée par l'usinage du germe cristallin SiC selon la revendication 1 ; et
une étape de croissance pour faire croître un monocristal de SiC dans le sens de l'axe "a" par un procédé d'épitaxie par solvant métastable, à l'aide du germe cristallin SiC dont la couche affectée par l'usinage est éliminée dans l'étape d'élimination.
